(19) **Europäisches Patentamt**

**European Patent Office**

**Office européen des brevets**

(11) **EP 0 805 492 B1**

(12) **EUROPÄISCHE PATENTSCHRIFT**

(45) Veröffentlichungstag und Bekanntmachung des Hinweises auf die Patenterteilung:
**30.06.2004 Patentblatt 2004/27**

(51) Int Cl.[7]: **H01L 23/14**, H01L 23/15, H01L 23/367, H01L 21/48, H01L 23/13

(21) Anmeldenummer: **97104225.4**

(22) Anmeldetag: **13.03.1997**

(54) **Gewölbtes Metall-Keramik-Substrat**

Curved metal ceramic substrate

Substrat métal céramique cintré en voûte

(84) Benannte Vertragsstaaten:
**DE FR GB IT**

(30) Priorität: **03.04.1996 DE 19613348**
**19.04.1996 DE 19615481**

(43) Veröffentlichungstag der Anmeldung:
**05.11.1997 Patentblatt 1997/45**

(73) Patentinhaber:
• **Schulz-Harder, Jürgen, Dr.-Ing.**
**D-91207 Lauf (DE)**
• **Maier, Peter H.**
**91207 Lauf (DE)**

(72) Erfinder:
• **Schulz-Harder, Jürgen, Dr.-Ing.**
**D-91207 Lauf (DE)**

• **Maier, Peter H.**
**91207 Lauf (DE)**

(74) Vertreter: **Graf, Helmut, Dipl.-Ing. et al**
**Patentanwalt**
**Postfach 10 08 26**
**93008 Regensburg (DE)**

(56) Entgegenhaltungen:
**EP-A- 0 468 475      EP-A- 0 650 189**
**DE-A- 3 940 933      US-A- 5 379 942**
**US-A- 5 461 774**

• **PATENT ABSTRACTS OF JAPAN vol. 014, no. 391 (E-0968), 23.August 1990 & JP 02 143583 A (MITSUBISHI ELECTRIC CORP), 1.Juni 1990,**

**Beschreibung**

Die Erfindung bezieht sich auf ein Verfahren zum Herstellen eines Metall-Keramik-Substrats gemäß Oberbegriff Patentanspruch 1.

Bekannt ist es, die zum Herstellen von Leiterbahnen, Anschlüssen usw. benötigte Metallisierung auf einer Keramik, z.B. auf einer Aluminium-Oxid-Keramik mit Hilfe des sogenannten "DCB-Verfahrens" (Direct-Copper-Bond-Technology) herzustellen, und zwar unter Verwendung von die Metallisierung bildenden Metall- bzw. Kupferfolien oder Metall- bzw. Kupferblechen, die an ihren Oberflächenseiten eine Schicht oder einen Überzug (Aufschmelzschicht) aus einer chemischen Verbindung aus dem Metall und einem reaktiven Gas , bevorzugt Sauerstoff aufweisen. Bei diesem beispielsweise in der US-PS 37 44 120 oder in der DE-PS 23 19 854 beschriebenen Verfahren bildet diese Schicht oder dieser Überzug (Aufschmelzschicht) ein Eutektikum mit einer Schmelztemperatur unter der Schmelztemperatur des Metalls (z.B. Kupfers), so daß durch Auflegen der Folie auf die Keramik und durch Erhitzen sämtlicher Schichten diese miteinander verbunden werden können, und zwar durch Aufschmelzen des Metalls bzw. Kupfers im wesentlichen nur im Bereich der Aufschmelzschicht bzw. Oxidschicht. Dieses DCB-Verfahren weist dann z.B. folgende Verfahrensschritte auf:

- Oxidieren einer Kupferfolie derart, daß sich eine gleichmäßige Kupferoxidschicht ergibt;
- Auflegen des Kupferfolie auf die Keramikschicht;
- Erhitzen des Verbundes auf eine Prozeßtemperatur zwischen etwa 1070 bis 1075°C, z.B. auf ca. 1071 °C;
- Abkühlen auf Raumtemperatur.

Bekannt ist es insbesondere auch (EP-A-0 468 475) derartige, unter Verwendung des DCB-Verfahrens hergestellte Substrate für die Herstellung von Halbleiter-Leistungs-Bauteilen zu verwenden.

Bekannt ist ferner ein gewölbtes Substrat (EP - A- 0 279 601), bei dem die Metallschicht an der Oberseite der Keramikschicht eine deutlich größere Dicke als die Metallschicht an der Unterseite dieses Substrates aufweist. Diese Ausbildung ist im bekannten Fall auch notwendig, da dort die Wölbung des fertiggestellten Substrates beim Abkühlen nach dem DCB-Prozeß erreicht werden soll, mit dem die beiden Metallisierungen auf der Keramikschicht befestigt werden. Da die Metallisierung an der Oberseite eine größere Dicke aufweist, sind thermisch bedingten Spannungen an der Oberseite größer als an der Unterseite, so daß sich das Substrat beim Abkühlen an der Oberseite konkav und an der Unterseite konvex wölbt. Dieser "Bimetall"-Effekt ist reversibel, d.h. bei einer Erwärmung tritt ein Rückbiegen auf, so daß bei Verwendung des bekannten Substrates für Leistungs-Bauelemente die Anpreßkraft zwischen Unterseite des Substrates und dem Kühlkörper bei steigender Erwärmung reduziert wird, d.h. gerade dann, wenn zur Erzielung eines besonders geringen Wärmeübergang zwischen dem Substrat und dem Kühlkörper eine hohe Anpreßkraft erforderlich ist.

Bekannt ist ferner ein Verfahren zum Herstellen eines Halbleitermodulaufbaus (EP-A-0 650 189) mit einer metallischen Bodenplatte, mit einem mit der Bodenplatte stoffschlüssig verbundenen, mit einer mit Metallisierungen versehenen Keramikschicht und mit mit einer Metallisierung stoffschlüssig verbundenen Halbleiterkörpern. Die Bodenplatte bildet mit ihrer konvex gewölbten frei liegenden Unterseite eine Anlagefläche zur Anlage gegen einen Kühlkörper. Zum Herstellen werden die Halbleiterkörper, die metallisierte Keramikschicht und die Bodenplatte in eine Elastomer-Preßform eingelegt. Anschließend wird auf die Bodenplatte ein beheizbarer Preßstempel mit einer konkaven Oberfläche aufgesetzt und hierbei zumindest die Bodenplatte und die Keramikschicht unter erhöhter Temperatur und unter Druck mittels eines Preßstempels verformt und verbunden. Die metallisierte Keramikschicht besteht hierbei vorzugsweise aus einer Keramikschicht, die beidseitig unter Verwendung des DCB-Verfahrens mit einer Kupferfolie versehen ist. Die Verbindung zwischen der einen Kupferfolie und der Bodenplatte erfolgt beim Preßformen z.B. durch Löten oder Diffusionsbonden.

Nachteilig ist u.a., daß die Keramikschicht erst beim Verbinden mit der Bodenplatte in die konkave Form geformt wird, so daß eine erhebliche Dauerbelastung in der Keramikschicht besteht. Nachteilig ist auch, daß der bekannte Halbleitermodulaufbau nach seiner Fertigstellung beidseitig von der Keramikschicht mit dieser verbundene Metallelemente unterschiedlicher Dikke aufweist, und zwar an der Oberseite eine dünne Metallisierung und an der Unterseite die Kombination aus einer dünnen Metallisierung und einer relativ dicken metallischen Bodenplatte.

Bekannt ist weiterhin ein Verfahren zum Verformen einer Basisplatte (DE-A-39 40 933), die aus mindestens zwei über eine Lotschicht miteinander verbundenen Platten mit unterschiedlichem Wärmeausdehnungskoeffizienten bestehen. Zum Verformen wird die Basisplatte in einer Preßschale einer Temperatur und einem Druck ausgesetzt, so daß zumindest die an der Preßschale anliegende Platte der Basisplatte sich an die Form der Preßschale anpaßt und dadurch eine bleibende Verformung der gesamten Basisplatte erzielt wird.

Aufgabe der Erfindung ist es, ein möglichst stressfreies Metall-Keramik-Substrat aufzuzeigen, welches für elektrische oder elektronische Leistungsschaltkreise oder - module geeignet ist und eine verbesserte, temperatur-unabhängige Wärmeableitung bei einfacher und problemloser Montage in einem Gehäuse gestattet.

Zur Lösung dieser Aufgabe ist ein Verfahren zur Herstellung dieses Metall-Keramik-Substrats entsprechend dem Patentanspruch 1 ausgebildet.

Durch die Krümmung des Substrates bzw. der Keramikschicht ist es möglich, dieses im Verwendungsfall elastisch derart eben zu biegen, daß das Substrat aufgrund der elastischen Spannung der Keramikschicht dicht und fest gegen eine Fläche einer Wärme ableitenden Metallplatte anliegt, und sich hierdurch eine verbesserte Wärmeableitung ergibt, insbesondere auch bei Verwendung einer Kühlpaste zwischen dem Substrat und der Metallplatte. Die Wölbung des Substrates dient also insbesondere dazu, eine optimale Anlage der Unterseite bzw. der unteren Metallisierung des Substrates an z.B. einer Metallplatte und damit einen möglichst optimalen Wärmeübergang zwischen dem Substrat und dieser beispielsweise einen Kühlkörper bildenden Metallplatte zu gewährleisten. Dieses durch die Vorkrümmung des Substrates erzielte, verbesserte Verbindung zwischen dem Substrat und der Metallplatte soll unabhängig von der jeweiligen Temperatur des Substrates bzw. der Metallplatte möglichst konstant sein. Diese Forderung ist dann nicht mehr erfüllt, wenn eine der beiden Metallschichten eine größere Dicke aufweist, da eine Metallisierung mit größerer Dicke und damit mit größerem Volumen bei Temperaturänderungen stärkere temperaturbedingte, sich ändernde Spannungen auf die betreffende Oberflächenseite der Keramikschicht ausübt. Unterschiedliche Dicken der beiden Metallisierungen auf der Oberseite und Unterseite würden somit zu einer temperaturabhängigen zusätzlichen Verwölbung des Substrates führen.

Bei dem Krümmungsgrad, welches die Erfindung vorsieht, ist auch ein Brechen der Keramikschicht mit Sicherheit vermieden. Weiterbildungen der Erfindung sind Gegenstand der Unteransprüche. Die Erfindung wird im folgenden anhand der Figuren an einem Ausführungsbeispiel näher erläutert. Es zeigen:

Fig. 1     in vereinfachter Darstellung und in Seitenansicht ein Substrat gemäß der Erfindung, zusammen mit einer unter dem Substrat angeordneten Metallplatte;

Fig. 2     eine Draufsicht auf das Substrat der Fig. 1;

Fig. 3     in vergrößerter Detaildarstellung einen Schnitt durch den in einem Gehäuse eingespannten Rand des Substrates;

Fig. 4     in Draufsicht verschiedene Formen eines Substrates der Erfindung.

Das in den Figuren dargestellte Substrat 1 besteht im wesentlichen aus einer Keramikschicht bzw. Keramikplatte 2, die beispielsweise eine Aluminiumoxid-Keramik ist und die an beiden Oberflächenseiten mit jeweils einer Metallisierung 3 bzw. 4 versehen ist. Die Metallisierungen 3 und 4 sind jeweils von einer Kupferfolie gebildet, die mit Hilfe der dem Fachmann bekannten DCB-Technik flächig mit der Keramikschicht 2 verbunden ist.

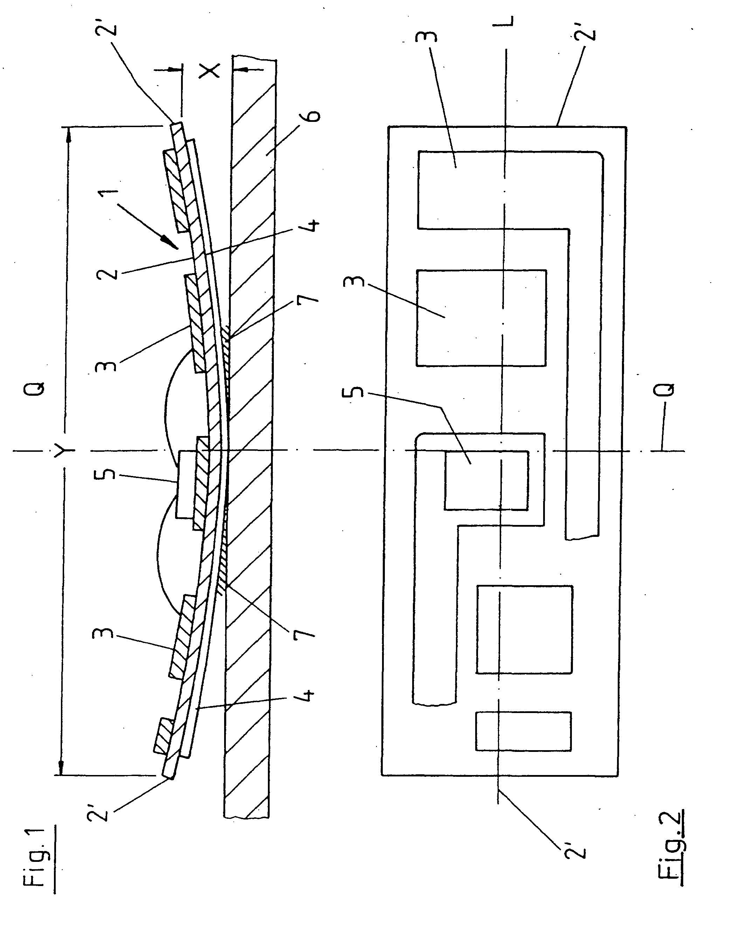

Bei der dargestellten Ausführungsform besitzt die Keramikschicht 2 in Draufsicht einen rechteckförmigen Zuschnitt mit der längeren Längsachse L und der hierzu senkrecht verlaufenden kürzeren Querachse Q. Die Keramikschicht 2 ist bei der dargestellten Ausführungsform um eine Achse parallel zur Querachse gewölbt oder gekrümmt, so daß die Oberseite der Keramikschicht 2 konkav und die Unterseite konvex ist. In gleicher Weise sind auch die dortigen Metallisierungen 3 und 4 gewölbt. Die Krümmungsachse ist in der Fig. 1 mit Q' angedeutet, besitzt aber tatsächlich einen wesentlich größeren Abstand vom Substrat 1, als in dieser Fig. gezeigt. Die Metallisierung 3 an der Oberseite ist strukturiert und bildet Leiterbahnen sowie Kontaktflächen, und zwar letztere insbesondere auch zum Befestigen, z.B. zum Auflöten von elektronischen Bauteilen 5. Die Metallisierung 4 an der Unterseite ist durchgehend ausgebildet.

Die Wölbung der Keramikschicht 2 ist derart, daß dann, wenn das Substrat mit der unteren Metallisierung 4 in der Mitte zwischen den beiden senkrecht zur Längsachse L und parallel zur Krümmungsachse Q' liegenden Querseiten 2' auf einer ebenen Fläche, beispielsweise auf der Oberseite einer ebenen Metallplatte 6 aufliegt, die Unterseite der Keramikschicht 2 an jeder Querseite 2' einen Abstand x von der Oberseite der Metallplatte 6 aufweist, der etwa 0, 1 - 0,8 % derjenigen Länge ist, die die gewölbte Keramikschicht 2 zwischen den beiden Seiten 2' besitzt, und zwar zzgl. der Dicke der unteren Metallisierung 4. Es gilt also

$$(0{,}001 \cdot y + d) \leq x \leq (0{,}008 \cdot y + d)$$

wobei y der Abstand der beiden Seiten 2' undd die Dicke des Materials der Metallisierung 4 sind.

Es hat sich gezeigt, daß die thermische Leitfähigkeit zwischen dem Substrat 1 und der Metallplatte 6, die beispielsweise Bestandteil einer Wärmesenke oder eines Gehäuses ist, wesentlich verbessert werden kann. Das Substrat 1 wird auf die an ihrer Oberseite mit einer Schicht aus einer Kühlpaste 7 versehene Platte 6 aufgelegt und dann am Rand und damit auch an den Schmalseiten 2' auf die Platte 6 gedrückt, womit durch die elastische Verformung der Keramikschicht 2 ein dichtes Anliegen der unteren Metallisierung 4 an der Metallplatte 6 und ein gleichmäßiges Verteilen der Kühlpaste 7 über die gesamte von der unteren Metallisierung 4 eingenommene Fläche der Metallplatte 6 erfolgt.

Der Erfindung liegt die Erkenntnis zugrunde, daß bei einer Krümmung, die im Rahmen der vorstehend genannten Grenzen liegt, die Keramikschicht 2 ohne Probleme, insbesondere auch ohne die Gefahr eines Bruches in eine ebene Form zurückgebogen werden kann, und zwar insbesondere auch dann, wenn die obere, an der konkaven Seite der Keramikschicht vorgesehene Metallisierung 3 strukturiert ist und somit zumindest in einem großen Teil der Oberseite der Keramikschicht keine durchgehende Metallisierung bildet, sondern in der Achsrichtung senkrecht zur Krümmungsachse nur jeweils kurze Abmessungen aufweist. Über die obere Metallisierung 3 können somit beim Rückbiegen des Substrates 1 in die ebene Form auch keine übermäßig hohen Zugkräfte zwischen der Keramikschicht 2 und der Metallisierung 3 auftreten.

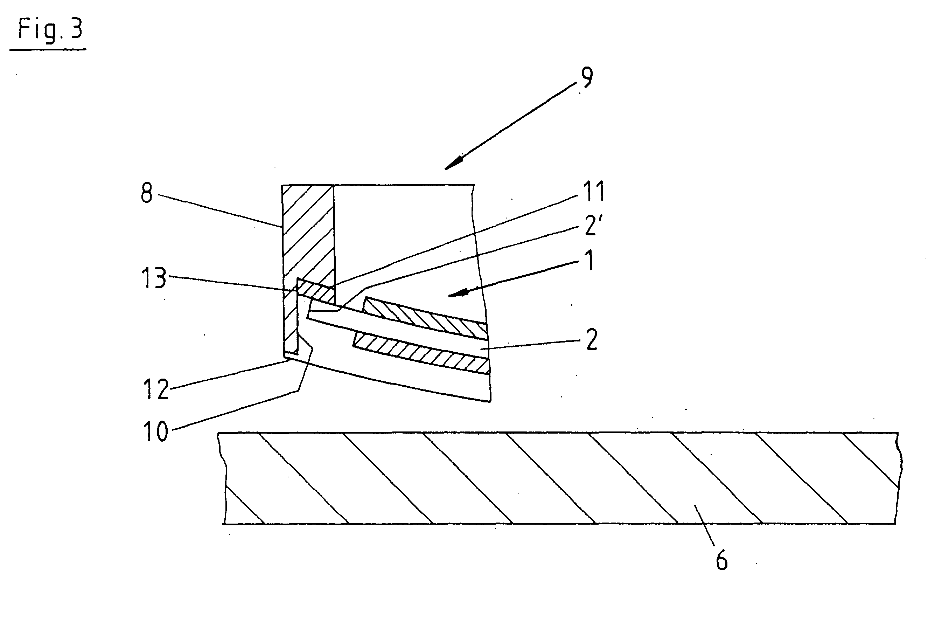

Fig. 3 zeigt die Einspannung des Substrates 1 am Rand, d.h. insbesondere auch im Bereich der beiden Schmalseiten 2' an dem einen rechteckförmigen Rahmen bildenden Teil 8 eines Gehäuses 9, mit dem das Substrat 1 dann an der den Teil der Wärmesenke bildenden Platte 6 unter Verwendung der Kühlpaste 7 befestigt werden kann. Zur Aufnahme des Randes des Substrates 1 besitzt das Gehäuseteil 8 eine falzartige Ausnehmung 10, die u.a. eine Anlagefläche 11 für die Abstützung der Oberseite der Keramikschicht 2 im Bereich des Randes bildet. Die Falz- oder Anlagefläche 11, aber auch die Unterseite 12 des Gehäuseteils 8 besitzen einen gekrümmten Verlauf, und zwar entsprechend der Wölbung des Substrates 1 bzw. der Keramikschicht 2. Zusätzlich zu dem vorstehend bereits beschriebenen Vorteil eines verbesserten Wärmeübergangs zwischen dem Substrat 1 und der Metallplatte 6 besteht auch der Vorteil, daß Spannungen zwischen dem Substrat 1 und dem Gehäuse 9 vermieden sind, insbesondere auch bei der Montage des Substrates 1 am Gehäuse 9.

Erst beim Befestigen auf der Metallplatte 6 werden das Substrat 1 und das Gehäuse 9 elastisch verformt.

Wie die Figur 3 zeigt, ist zwischen dem Rand der Keramikschicht 2 und der Falzfläche 11 eine Zwischenschicht 13 aus einer dauerelestischen Masse, vorzugsweise aus einem dauerelastischen Kleber vorgesehen.

Bei der vorbeschriebenen Ausführungsform wurde davon ausgegangen, daß das Substrat 1 nur um die Achse Q' gekrümmt ist. Grundsätzlich ist es aber auch möglich, das Substrat so auszuführen, daß es um zwei senkrecht zueinander verlaufende Achsen, nämlich um die Achse Q' parallel zur Querachse Q und zugleich auch um eine Achse parallel zur Längsachse L gekrümmt ist, und zwar wiederum um beide Achsen konkav an der Oberseite, so daß das Substrat beispielsweise an der Unterseite bzw. an der dortigen Metallisierung 4 eine konvex gewölbte Fläche entsprechend einer Teilfläche einer Kugeloberfläche besitzt.

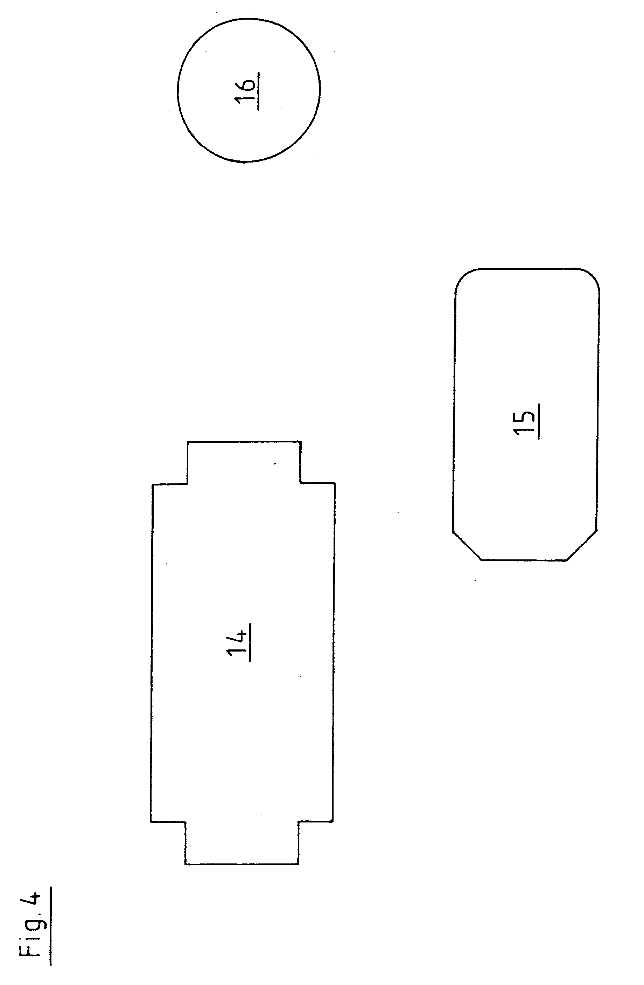

Bei der vorgeschriebenen Ausführungsform wurde davon ausgegangen, daß das Substrat einen rechteckförmigen Zuschnitt, d.h. in Draufsicht eine rechteckförmige Ausbildung aufweist. Auch andere Formen sind für das Substrat denkbar, beispielsweise das in der Figur 4 wiedergegebenen Substrat 14, dessen Form sich aus einer rechteckförmigen oder quadratischen Grunform mit Vorsprüngen an zwei gegenüberliegenden Seiten zusammensetzt, oder das rechteckförmige Substrat 15 mit abgerundeten und/oder abgeschrägten Ecken und/oder das runde Substrat 16.

## Bezugszeichenliste

| | |
|---|---|
| 1 | Substrat |
| 2 | Keramikschicht |
| 2' | Querseite |
| 3, 4 | Metallisierung |
| 5 | Halbleiterbauelement |
| 6 | Metallplatte |
| 7 | Kühlpaste |
| 8 | Gehäuseteil |
| 9 | Gehäuse |
| 10 | Gehäusefalz |
| 11 | Falzfläche |
| 12 | Unterseite |
| 13 | dauerelestische Masse |
| 14, 15, 16 | Substrat |
| L, Q, Q' | Achse |
| x | Abstand |
| y | Länge |

## Patentansprüche

1. Verfahren zum Herstellen eines Metall-Keramik-Substrats, welches aus einer Keramikschicht (2) mit jeweils einer an der Oberseite und an der Unterseite der Keramikschicht (2) vorgesehenen Metallisierung (3, 4) besteht und um wenigstens eine Achse (Q') parallel zur Ebene des Substrates derart gekrümmt ist, daß es an der Unterseite eine konvex gekrümmte Fläche bildet und der Abstand (x), den ein parallel zur Krümmungsachse liegender Rand (2') des Substrates (1, 14, 15, 16) von einer die Mitte der Krümmung oder des Substrates (1, 14, 15, 16) tangential berührenden Ebene (6) aufweist, zwischen etwa 0,1 - 0,8 % der Längenabmessung (y) ist, die das Substrat (1, 14, 15, 16) oder die Keramikschicht (2) in Richtung senkrecht zur Achse (Q') der Krümmung oder in Richtung senkrecht zum Rand (2') besitzt, und zwar zuzüglich der Dicke der Metallisierung (4) an der konvex gewölbten Unterseite der Keramikschicht (2), und zwar entsprechend der nachfolgenden Beziehung

$$(0,001 \cdot y + d) \leq x \leq (0,008 \cdot y + d)$$

wobei y die Längenabmessung und d die Dicke des Materials der Metallisierung (4) sind, wobei die Metallisierung an der Unterseite der Keramikschicht (2) mit ihrer der Keramikschicht abgewandten Oberflächenseite die Unterseite des Metall-Keramik-Substrats bildet, mit der das Metall-Keramik-Substrat gegen eine Wärmesenke oder einen Kühlkörper anpreßbar ist, **dadurch gekennzeichnet,**

**daß** die Metallisierungen (3, 4) als Metallfolien gleicher Dicke auf die vorgewölbte Keramikschicht (2) aufgebracht werden.

## Claims

1. Method for manufacturing a metal-ceramic substrate which comprises a ceramic layer (2) with a metal coating (3, 4) provided respectively on the upper face and underside of the ceramic layer (2), and which is curved around at least one axis (Q') parallel to the plane of the substrate, such that on the underside it forms a surface curved in a convex manner, and the distance (x) between an edge (2') of the substrate (1, 14, 15, 16) which [edge] runs parallel to the curvature axis and a plane (6) that tangentially touches the middle of the curvature or of the substrate (1, 14, 15, 16) is between about 0.1 - 0.8% of the longitudinal dimension (y) that the substrate ( 1, 14, 15, 16) or the ceramic layer (2) has in the direction perpendicular to the axis (Q') of the curvature or in the direction perpendicular to the edge (2'), and in fact plus the thickness of the metal coating (4) on the convexly-curved under underside of the ceramic layer (2), and in fact in accordance with the following relation

   $$(0.\ 001 \times y + d) \leq x \leq (0.008 \times y + d)$$

   wherein y is the length dimension and d is the thickness of the material of the metal coating (4), wherein with its surface side that faces away from the ceramic layer, the metal coating on the underside of the ceramic layer (2) forms the underside of the metal-ceramic substrate, with which the metal-ceramic substrate can be pressed against a heat sink or a cooling body, **characterised in that** the metal coatings (3, 4) are applied as metal foils of the equal thickness onto the pre-curved ceramic layer (2).

## Revendications

1. Procédé de fabrication d'un substrat de métal-céramique, qui est constitué d'une couche de céramique (2) portant une couche métallisée appliquée, respectivement, sur la face supérieure et la face inférieure de la couche de céramique (2) et est cintré autour d'au moins un axe (Q') parallèle au plan du substrat de sorte qu'il forme, sur la face inférieure, une surface à cintrage convexe et que la distance (x), que présente un bord (2') - disposé parallèlement à l'axe de cintrage - du substrat (1, 14, 15, 16) par rapport à un plan (6) en contact tangentiel avec le centre du cintrage ou du substrat (1, 14, 15, 16), se situe entre environ 0,1 et 0,8% de la dimension longitudinale (y), qu'occupe le substrat (1, 14, 15, 16) ou la couche de céramique dans la direction perpendiculaire à l'axe (Q') du cintrage ou dans la direction perpendiculaire au bord (2'), plus l'épaisseur de la couche métallisée sur la face inférieure à cintrage convexe de la couche de céramique (2), et ce, conformément à la relation suivante :

   $$(0,001 \cdot y + d) \leq x \leq (0,008 \cdot y + d)$$

   dans laquelle y est la dimension longitudinale et d est l'épaisseur du matériau de la couche métallisée (4), la couche métallisée appliquée sur la face inférieure de la couche de céramique (2) formant avec sa face supérieure opposée à la couche de céramique la face inférieure du substrat de métal-céramique, par laquelle le substrat de métal-céramique peut être appliqué contre un puits de chaleur ou un corps réfrigérant, **caractérisé en ce que** les couches métallisées (3, 4) sont appliquées sur la couche de céramique précintrée (2) sous la forme de films métalliques de même épaisseur.

Fig.1

Fig.2

## Fig. 3

Fig. 4

14

15

16